Europäisches Patentamt

European Patent Office

Office européen des brevets

(19)

(11) **EP 0 673 114 B1**

(12) **EUROPÄISCHE PATENTSCHRIFT**

(45) Veröffentlichungstag und Bekanntmachung des Hinweises auf die Patenterteilung:
**03.06.1998 Patentblatt 1998/23**

(51) Int Cl.⁶: **H03H 17/04**

(21) Anmeldenummer: **95103437.0**

(22) Anmeldetag: **09.03.1995**

(54) **Verfahren zur Filterung einer digitalen Wertefolge mit verbessertem Rauschverhalten und Schaltungsanordnung zur Durchführung des Verfahrens**

Filtering method with ameliorated noise characteristics for a series of digital values and circuit for implementing the method

Procédé de filtrage d'une série de valeurs numériques à comportement au bruit améliorée et circuit pour mettre en oeuvre la méthode

(84) Benannte Vertragsstaaten:
**DE FR GB IT NL**

(30) Priorität: **15.03.1994 DE 4408768**

(43) Veröffentlichungstag der Anmeldung:
**20.09.1995 Patentblatt 1995/38**

(73) Patentinhaber: **SIEMENS AKTIENGESELLSCHAFT
80333 München (DE)**

(72) Erfinder:
• **Gazsi, Lajos, Dr. Ing.
D-40239 Düsseldorf (DE)**
• **Leeb, Ferenc, Dr.
A-9500 Villach (AT)**

(56) Entgegenhaltungen:
**US-A- 4 236 224**

• **IEEE TRANSACTIONS ON ACOUSTICS, SPEECH AND SIGNAL PROCESSING, Bd. 27, Nr. 2, April 1979 NEW YORK US, Seiten 195-198, AHMAD I. ABU-EL-HAIJA ET AL 'AN APPROACH TO ELIMINATE ROUNDOFF ERRORS IN DIGITAL FILTERS'**
• **IEEE TRANSACTIONS ON CIRCUITS AND SYSTEMS, Bd. 36, Nr. 4, April 1989 NEW YORK US, Seiten 618-622, XP 000034090 SHU-HUNG LEUNG 'A REALIZATION OF NARROW-BAND RECURSIVE DIGITAL LOW-PASS FILTER USING HIGHLY QUANTIZED COEFFICIENTS'**

**Beschreibung**

Die Erfindung betrifft ein Verfahren gemäß dem Oberbegriff des Anspruchs 1 bzw. eine Schaltungsanordnung gemäß dem Oberbegriff des Anspruchs 4.

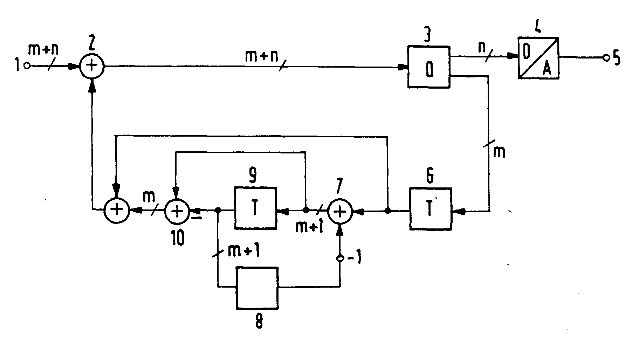

Ein derartiges Verfahren bzw. eine Anordnung ist z. B. aus "A 16-Bit 4'th Order Noise-Shaping D/A Converter" von Carley und Kenney aus IEEE 1988 Custom Integrated Circuits Conference auf Seite 21.7.1 ff bekannt. Insbesondere auf Seite 21.7.1 ist in Figur 1 ein derartiges System dargestellt.

Bei Delta-Sigma-Modulatoren tritt bei Eingabe von digitalen Nullwerten am Ausgang eines Digital-Analog-Wandlers ein Rauschsignal mit verschieden stark ausgeprägten harmonischen Komponenten auf, die aufgrund eines verwendeten vorgeschalteten Noise-Shaping-Filters entstehen. Aus IEEE Journal of Solid-State Circuits, Vol. 23, No. 6, December 1988 auf Seite 1351 ff und aus IEEE 1990 CH 2868-8/90/0000-Seite 895 ff und dem zuvor genannten Dokument sind verschiedene Verfahren zur Verbesserung des Signalrauschabstands bei derartigen Einrichtungen bekannt. Diese Verfahren sind jedoch relativ aufwendig.

Derartige Noise-Shaper zweiter Ordnung produzieren abhängig von ihrem internen Zustand (d.h. Speicherinhalt) Grenzzyklen, wodurch harmonische Komponenten im Rauschsignal eines nachgeschalteten D-A-Wandlers entstehen und verstärkt werden können. Aufgabe der vorliegenden Erfindung ist es daher, ein Verfahren zur Filterung einer digitalen Wertefolge mit verbessertem Rauschverhalten und eine Schaltungsanordnung zur Durchführung des Verfahrens anzugeben, welches möglichst einfach aufgebaut ist und einen hohen Wirkungsgrad aufweist.

Diese Aufgabe wird durch den kennzeichnenden Teil des Anspruchs 1 bzw. 4 gelöst. Weiterbildungen sind Kennzeichen der Unteransprüche.

Die digitale Filterung einer Wertefolge gemäß dem erfindungsgemäßen Verfahren hat den Vorteil, daß keine Grenzzyklen entstehen. Diese Grenzzyklen bewirken in bisherigen Filtern das Entstehen von harmonischen Komponenten im Rauschsignal.

Die Erfindung wird nachfolgend anhand einer Figur näher erläutert.

In der einzigen Figur 1 ist mit 1 eine Anschlußklemme dargestellt, die mit dem ersten Eingang eines Addierers 2 verbunden ist. Der Verbindungsbus zwischen Anschlußklemme 1 und Addierer 2 kann z.B. m+n=16 Bit breit sein. Der Verbindungsbus führt dann z.B. ein 16-Bit Datenwort. Der Ausgang des Addierers 2 ist mit dem Eingang eines Teilers 3 verbunden, an dessen Ausgang n-Leitungen der MSB und z.B. m-Leitungen der LSB des Datenworts zur Verfügung gestellt werden. Die höherwertigen n MSB-Leitungen können z.B. die oberen 8 Bits eines 16 Bit-Datenworts sein und werden einem Digital-Analog-Wandler 4 zugeführt. Der Ausgang des Digital-Analog-Wandlers 4 ist mit einer Anschlußklemme 5 verbunden. Die niederwertigen m-LSB-Leitungen, z.B. die unteren 8 Bits eines 16 Bit-Datenworts werden einem Zeitverzögerungsglied 6 zugeführt. Dieses m-Bit Datenwort wird dabei grundsätzlich als positive Zahl betrachtet. Dies kann z.B. dadurch erfolgen, daß ein zusätzliches höchstwertiges Bit eingeführt wird, welches mit dem Wert "0" besetzt wird. Der Ausgang des Zeitverzögerungsglieds 6 ist mit dem ersten Eingang eines Addierers 7 und mit dem ersten Eingang eines Addierers 11 verbunden. Der Ausgang des Addierers 7 ist mit dem ersten Eingang eines Addierers 10 und einem zweiten Verzögerungsglied 9 verschaltet. Das Ausgangssignal des Verzögerungsglieds 9 wird einer Schiebeeinheit 8 und das Zweierkomplement des Ausgangssignals dem zweiten Eingang des Addierers 10 zugeführt. Das Zweierkomplement des Ausgangssignals der Schiebeeinheit 8 wird dem zweiten Eingang des Addierers 7 zugeführt. Der Ausgang des Addierers 10 ist mit dem zweiten Eingang des Addierers 11 verschaltet. Der Ausgang des Addierers 11 ist mit dem zweiten Eingang des Addierers 2 verbunden. Die Addierer 7 und 10 sowie das Zeitverzögerungsglied 9 und die Schiebeeinrichtung 8 sind um wenigstens ein niederwertigstes Bit erweitert, so daß in diesem Bereich mit wenigstens m+1 Bits gerechnet wird. Entsprechend notwendige MSB-Bits sind im gesamten Rückkopplungsbereich vorgesehen, so daß kein Überlauf auftritt. Das zusätzliche niederwertigste Bit bleibt ab dem Addierer 11 unberücksichtigt. Selbstverständlich kann auch die gesamte Anordnung bereits in allen Stufen diese Erweiterung um das niederwertigste Bit vorsehen, jedoch muß dieses Bit erfindungsgemäß spätestens beim Addierer 2 unberücksichtigt bleiben. Sinngemäß kann es dann frühestens nach dem Teiler für die m Bits berücksichtigt werden.

Die gesamte Anordnung kann vorzugsweise durch einen Signalprozessor realisiert werden. Die Anordnung kann aber auch fest verdrahtet aufgebaut werden. Die einzelnen Additionsoperationen müssen sinngemäß mit gesättigten bzw. ungesättigten Addierern durchgeführt werden, wie es im einzelnen aus dem Stand der Technik bei digitalen Filterschaltungen bekannt ist.

Das in der Figur 1 dargestellte Noise-Shaping Filter arbeitet nach folgendem Prinzip:

Bezeichnet man die Ausgangswertfolge am Ausgang des Addierers 2 mit y(t), so gilt:

$$y(t) = x(t) + a(t),$$

wobei x(t) die Eingangswertfolge an der Klemme 1 und a(t) die Rückkopplungswertfolge am zweiten Eingang des Addierers 2 bezeichnet.
Die Rückkopplungswertfolge a(t) ergibt sich zu:

$$a(t) = 2 \cdot x_0(t) - x_1(t) - sh(m) [x_1(t)],$$

wobei $x_0(t)$ die im Speicher 6 gespeicherte Variable und $x_1(t)$ die im Speicher 9 gespeicherte Variable ist. Unter sh(m) [$x_1(t)$] ist das arithmetische Rechtsschieben (in Richtung LSB) um m Stellen der Variablen $x_1(t)$ in der Einheit 8 zu verstehen.

Die Wertefolge $x_0(t)$ ist definiert zu:

$$x_0(t) = Q_m[y(t-1)],$$

wobei $Q_m[y(t-1)]$ die Funktion der Abtrennung der unteren m Bits des Werts y(t-1) bezeichnet und wobei $x_0(t)$ immer als positiv zu betrachten ist. An dieser Stelle kann auch z.B. die Erweiterung um das zusätzliches LSB-Bit sowie um wenigstens ein zusätzliches MSB-Bit erfolgen, welche auf Null gesetzt werden.

Das zusätzliche LSB-Bit kann frühestens nach der Teilung des Ausgangswerts y(t) berücksichtigt werden, wobei es nur für die Operation

$$b(t) = x_0(t) - x_1(t) - sh(m) [x_1(t)]$$

erfindungsgemäß benötigt wird, hierbei gilt:

$$a(t) = x_0(t) + b(t).$$

Das zusätzliche MSB-Bit kann ebenfalls frühestens nach der Auftrennung des zuvor genannten Additionswerts erzeugt werden, um die m-Bits als positive Zahl darzustellen.

Die Wertefolge $x_1(t)$ ist definiert zu:

$$x_1(t) = x_0(t-1) - sh(m) [x_1(t-1)],$$

wobei wiederum die zuvor gemachten Ausführungen gelten. Für t gilt: t = 0, 1, 2..., wobei für t = 0 die sich ergebenden Werte von $x_0(-1)$ und $x_1(-1)$ die jeweils vorbesetzten Werte der Speicherzellen sind.

Liegen an der Eingangsklemme 1 z.B. digitale Werte eines zuvor kodierten Sprachsignals an, so verhält sich die gesamte Anordnung wie ein normales Noise-Shaping-Filter und an der Ausgangsklemme 5 können die übertragenen kodierten Sprachsignale abgegriffen werden.

Liegt jedoch an der Eingangsklemme 1 z.B. während einer Sprechpause ein fortwährend dauerndes digitales "Null"-Signal an, so werden die harmonischen Signalanteile im Rauschen, welche sonst üblicherweise durch die gesamte Anordnung aufgrund von Grenzzyklen erzeugt würden, durch das Vorsehen der Schiebeeinheit 8 stark reduziert. Die Schiebeeinheit 8 ist in dem um wenigstens ein niederwertiges Bit erweiterten Rückkopplungszweig des Filters vorgesehen und schiebt den Wert am Ausgang des Zeitverzögerungsglieds 9 um m Stellen nach rechts, im zuvor beschriebenen Beispiel also um 7 Stellen, und führt sie dem zweiten Eingang des Addierers 7 als Zweierkomplement zu, so daß dieser Wert von dem am Ausgang des Zeitverzögerungsglieds 6 anliegenden Wert abgezogen wird. Durch diese Maßnahme werden die harmonischen Anteile im Rauschsignal des Systems, welche durch Eigendynamik des rückgekoppelten Filtersystems entstehen, stark reduziert. In Messungen hat sich gezeigt, daß diese Peaks innerhalb eines Rauschsignals durch die erfindungsgemäße Anordnung fast vollständig eliminiert werden können.

Spätestens ab dem Addierer 7 bis zum Addierer müssen n+q Leitungen, z.B. 12 Bits, vorgesehen sein um einen Überlauf der Anordnung zu verhindern bzw. um die zusätzlichen MSB- bzw. LSB- Bits bereitzustellen.

## Patentansprüche

1. Verfahren zur Filterung eines digitalen Werts mit verbessertem Rauschverhalten,
   **dadurch gekennzeichnet,**

   - daß der digitale Ausgangswert (y(t)) die Summe aus digitalem Eingangswert (x(t)) und einem Rückkopplungswert (a(t)) ist,
   - daß der Rückkopplungswert (a(t)) gleich einer ersten Variablen ($x_0(t)$) subtrahiert mit einer zweiten Variablen ($x_1(t)$) und subtrahiert mit der um m Stellen nach rechts geschobenen zweiten Variablen ($x_1(t)$) und addiert mit der ersten Variablen ($x_0(t)$) ist,

   wobei die erste Variable ($X_0(t)$) gleich den unteren m Bits des vorherigen digitalen Ausgangswerts (y(t-1)) entspricht und immer einen positiven Wert darstellt und die zweite Variable ($x_1(t)$) gleich der vorherigen ersten Variablen ($x_0(t-1)$) subtrahiert mit der um m Bits arithmetisch nach rechts geschobenen vorherigen zweiten Variablen ($x_1(t-1)$) entspricht und die Berechnung des Rückkopplungswerts (a(t)) mit wenigstens einem zusätzlichem niederwertigen Bit bis wenigstens zur letzten Addition mit der ersten Variablen ($x_0(t)$) erfolgt und die Erweiterung nachfolgend unberücksichtigt bleibt.

2. Verfahren nach Anspruch 1,
   **dadurch gekennzeichnet,** daß die Darstellung der unteren m Bits als positive Zahl durch eine Erweiterung um wenigstens ein zusätzliches höchstwertiges Bit, welches auf Null gesetzt wird, erfolgt.

3. Schaltungsanordnung zur Durchführung des Verfahrens nach einem der vorhergehenden Ansprüche 1 oder 2 mit einem einem Digital-Analog-Wandler (4) vorgeschalteten Filter,
   **dadurch gekennzeichnet,**

daß das Filter

- eine erste Addierstufe (2) aufweist, deren erstem Eingang die zu wandelnden m+n Bits eines Datenworts zugeführt werden und deren Ausgang mit einer Teilerstufe (3) verbunden ist, von der die oberen n-Bits dem Digital-Analog-Wandler (4) und die unteren m-Bits einer ersten Haltestufe (6) zugeführt werden,
- eine zweite Addierstufe (7) enthält, deren erster Eingang mit dem Ausgang der ersten Haltestufe (6) und dem ersten Eingang einer dritten Addierstufe (11) verbunden ist,
- eine zweite Haltestufe (9) aufweist, deren Eingang mit dem Ausgang der zweiten Addierstufe (7) und dem ersten Eingang einer vierten Addierstufe (10) verbunden ist, wobei das Zweierkomplement des Ausgangssignal der zweiten Haltestufe (9) dem zweiten Eingang der vierten Addierstufe (10) zugeführt wird und der Ausgang der vierten Addierstufe (10) mit dem zweiten Eingang der dritten Addierstufe (11) und der Ausgang der dritten Addierstufe (11) mit dem zweiten Eingang der ersten Addierstufe (2) verbunden ist,
- eine Schiebeeinrichtung (8) aufweist, deren Eingang mit dem Ausgang der zweiten Haltestufe (9) und deren Ausgang über einen Zweierkomplementbilder mit dem zweiten Eingang der Addierstufe (7) verbunden ist, wobei die Schiebeeinrichtung (8) das am Eingang anliegenden Datenwort um m Bits nach rechts schiebt.

4. Schaltungsansordnung nach Anspruch 3, **dadurch gekennzeichnet,** daß wenigstens die zweite und vierte Addierstufe (7, 10), die zweite Haltestufe (9) und die Schiebeeinrichtung (8) um wenigstens ein niederwertiges Bit erweitert sind.

5. Schaltungsansordnung nach Anspruch 3, **dadurch gekennzeichnet,** daß alle Einheiten (2, 3, 6, 7, 8, 9, 10, 11) um wenigstens ein niederwertiges Bit erweitert sind, wobei dieses niederwertigste Bit nur bei der zweiten und vierten Addierstufe (7, 10), der zweiten Haltestufe (9) und der Schiebeeinrichtung (8) berücksichtigt wird.

## Claims

1. Method for filtering a digital value having an improved noise behaviour, characterized

    - in that the digital initial value (y(t)) is the sum of the digital input value (x(t)) and a feedback value (a(t)), and
    - in that the feedback value (a(t)) is equal to a first variable ($x_0(t)$) less a second variable ($x_1(t)$), less the second variable ($x_1(t)$) shifted by m digits to the right and plus the first variable ($x_0(t)$),

    the first variable ($x_0(t)$) being equal to the less significant m bits of the preceding digital initial value (y(t-1)) and always representing a positive value, and the second variable ($x_1(t)$) being equal to the previous first variable ($x_0(t-1)$) less the previous second variable ($x_1(t-1)$) shifted arithmetically to the right by m bits, and the calculation of the feedback value (a(t)) being carried out with at least one additional less significant bit at least until the final addition to the first variable ($x_0(t)$), and the continuation subsequently being ignored.

2. Method according to Claim 1, characterized in that the representation of the less significant m bits as a positive number is carried out by a continuation by at least one additional most significant bit, which is set to zero.

3. Circuit arrangement for carrying out the method according to one of the preceding Claims 1 or 2 using a filter connected upstream of a digital/analogue converter (4), characterized in that the filter

    - has a first adder stage (2) to whose first input the m+n bits of a data word to be converted are supplied and whose output is connected to a divider stage (3) from which the more significant n bits are supplied to the digital/analogue converter (4) and the less significant m bits are supplied to a first hold stage (6).
    - has a second adder stage (7), whose first input is connected to the output of the first hold stage (6) and to the first input of a third adder stage (11),
    - has a second hold stage (9), whose input is connected to the output of the second adder stage (7). and to the first input of a fourth adder stage (10), the two's complements of the output signal of the second hold stage (9) being supplied to the second input of the fourth adder stage (10), the output of the fourth adder stage (10) being connected to the second input of the third adder stage (11), and the output of the third adder stage (11) being connected to the second input of the first adder stage (2), and
    - has a shift device (8), whose input is connected to the output of the second hold stage (9) and whose output is connected via a two's complement format to the second input of the adder stage (7), the shift device (8) shifting the data word present at the input by m bits to the right.

4. Circuit arrangement according to Claim 3, characterized in that at least the second and the fourth adder stages (7, 10), the second hold stage (9) and the shift device (8) are continued by at least one less significant bit.

5. Circuit arrangement according to Claim 3, characterized in that all the units (2, 3, 6, 7, 8, 9, 10, 11) are continued by at least one less significant bit, this least significant bit being considered only in the second and the fourth adder stages (7, 10), the second hold stage (9) and the shift device (8).

**Revendications**

1. Procédé de filtrage d'une valeur numérique à comportement au bruit amélioré, caractérisé

   - en ce que la valeur de sortie numérique ($y(t)$) est la somme de la valeur d'entrée numérique ($x(t)$) et d'une valeur de rétroaction ($a(t)$),
   - en ce que la valeur de rétroaction ($a(t)$) est égale à une première variable ($x_0(t)$), de laquelle est soustraite une deuxième variable ($x_1(t)$) et de laquelle est soustraite la deuxième variable ($x_1(t)$) décalée de m chiffres vers la droite et à laquelle est additionnée la première variable ($x_0(t)$),

   la première variable ($x_0(t)$) étant égale aux m bits inférieurs de la valeur de sortie numérique précédente ($y(t-1)$) et représentant toujours une valeur positive, la deuxième variable ($x_1(t)$) étant égale à la première variable précédente ($x_0(t-1)$), de laquelle est soustraite la deuxième variable précédente ($x_1(t-1)$) décalée arithmétiquement de m bits vers la droite, et le calcul de la valeur de rétroaction ($a(t)$) étant effectué avec au moins un bit de faible poids supplémentaire au moins jusqu'à la dernière addition de la première variable ($x_0(t)$), et l'extension n'étant pas prise en compte par la suite.

2. Procédé selon la revendication 1, caractérisé en ce que la représentation des m bits inférieurs sous forme de nombre positif est effectuée par extension en introduisant au moins un bit de plus fort poids supplémentaire, lequel est mis à zéro.

3. Circuit pour la mise en oeuvre du procédé selon l'une des revendications précédentes 1 ou 2, comprenant un filtre placé en amont d'un convertisseur numérique-analogique (4), caractérisé en ce que le filtre comporte

   - un premier niveau d'addition (2) dont la première entrée reçoit les m+n bits à convertir d'un mot de données et dont la sortie est reliée à un niveau de division (3), à partir duquel les n bits supérieurs sont transmis au convertisseur numérique-analogique (4) et les m bits inférieurs à un premier niveau d'arrêt (6),

   - un deuxième niveau d'addition (7) dont la première entrée est reliée à la sortie du premier niveau d'arrêt (6) et à la première entrée d'un troisième niveau d'addition (11),
   - un deuxième niveau d'arrêt (9) dont l'entrée est reliée à la sortie du deuxième niveau d'addition (7) et à la première entrée d'un quatrième niveau d'addition (10), le complément de deux du signal de sortie du deuxième niveau d'arrêt (9) étant transmis à la deuxième entrée du quatrième niveau d'addition (10) et la sortie du quatrième niveau d'addition (10) étant reliée à la deuxième entrée du troisième niveau d'addition (11) et la sortie du troisième niveau d'addition (11) à la deuxième entrée du premier niveau d'addition (2),
   - un dispositif de décalage (8) dont l'entrée est reliée à la sortie du deuxième niveau d'arrêt (9) et la sortie, via un générateur de complément de deux, à la deuxième entrée du niveau d'addition (7), le dispositif de décalage (8) décalant le mot de données appliqué à l'entrée de m bits vers la droite.

4. Circuit selon la revendication 3, caractérisé en ce qu'au moins le deuxième et le quatrième niveau d'addition (7, 10), le deuxième niveau d'arrêt (9) et le dispositif de décalage (8) sont étendus d'au moins un bit de faible poids.

5. Circuit selon la revendication 3, caractérisé en ce que l'ensemble des unités (2, 3, 6, 7, 8, 9, 10, 11) sont étendues d'au moins un bit de faible poids, ce bit de plus faible poids étant pris en compte uniquement au deuxième et quatrième niveau d'addition (7, 10), au deuxième niveau d'arrêt (9) et au dispositif de décalage (8).